(19) Europäisches Patentamt

European Patent Office

Office européen des brevets

(11) Veröffentlichungsnummer: **0 278 485 B1**

(12) **EUROPÄISCHE PATENTSCHRIFT**

(45) Veröffentlichungstag der Patentschrift: **16.12.92**

(21) Anmeldenummer: **88101905.3**

(22) Anmeldetag: **10.02.88**

(51) Int. Cl.⁵: **G06K 11/06**, H05K 3/40, H05K 3/16, H05K 3/46

(54) Verfahren zur Herstellung eines Digitalisiertabletts.

(30) Priorität: **13.02.87 DE 3704497**

(43) Veröffentlichungstag der Anmeldung:
**17.08.88 Patentblatt 88/33**

(45) Bekanntmachung des Hinweises auf die Patenterteilung:
**16.12.92 Patentblatt 92/51**

(84) Benannte Vertragsstaaten:
**AT BE CH DE ES FR GB GR IT LI LU NL SE**

(56) Entgegenhaltungen:
**DE-A- 2 201 034      DE-A- 2 401 609**
**DE-A- 3 527 967      FR-A- 1 281 829**
**FR-A- 2 296 347      GB-A- 2 078 448**
**GB-A- 2 127 979      GB-A- 2 157 085**

(73) Patentinhaber: **Aristo Graphic Systeme GmbH & Co KG**
**Schnackenburgallee 41**
**W-2000 Hamburg 50(DE)**

(72) Erfinder: **Schrodt, Hans-Joachim**
**Willhöden 24**
**W-2000 Hamburg 55(DE)**

EP 0 278 485 B1

# Beschreibung

Verfahren zur Herstellung eines Digitalisiertabletts mit zwei Gruppen von jeweils innerhalb der Gruppe parallelen Leiterbahnen, die senkrecht zueinander verlaufen und fast koplanar angeordnet sind, bei dem die Leiterbahnen einer Gruppe jeweils durch Kathodenzerstäubung oder Aufdampfen von Metallen hergestellt werden, dann eine Isolierschicht unter Aussparung entsprechender Kontaktierungsbereiche aufgebracht wird und anschließend mittels elektrisch leitfähiger oder metallisierbarer Druckfarben weitere Leiterstrukturen vorgesehen werden.

Bei bekannten Verfahren zur Herstellung von Leiterplatten (z.B. DE-OS 35 27 967) werden mit Emaille beschichtete Stahlsubstrate verwendet, auf welche eine Metallisierung durch Hochfrequenzzerstäubung aufgebracht wird. Zur Herstellung eines Leiterbahnmusters wird ein Muster aus Fotolack aufgebracht und mit einer Goldschicht versehen. Nach dem Entfernen der Fotolackschicht mit der darauf angeordneten Goldschicht werden die freiliegenden Teile der Kupferschicht weggeätzt.

Nachteilig an diesem Verfahren ist, daß es sehr aufwendig ist und außerdem die Trägerfolie relativ steif sein muß, da Email im Vergleich zu Kupfer und anderen Metallen spröde und somit bruchempfindlich ist.

Aus einer weiteren Vorveröffentlichung (DE-OS 24 01 609) ist ein Verfahren zur Herstellung von beispielsweise Leiterplatten beschrieben, bei dem dünne Metallfolien als Aufdampfmasken verwendet werden, die lösbar befestigt auf einem Trägerrahmen aufliegen. Diese Masken müssen, damit sie glatt aufliegen, durch Aufheizung der Randbereiche des Trägerrahmens gespannt werden.

Nachteilig bei diesem Herstellverfahren ist, daß ein relativ steifes Substrat als Trägermaterial für die Leiterbahn erforderlich ist, und daß die Enden der Leiterbahnen durch anzulötende Leitungsdrähte miteinander verbunden werden müssen, da es nicht möglich ist, diese Verbindung einfach beim Herstellen der parallelen Leiterbahnen mit herzustellen. Dies würde nämlich dazu führen, daß die andere Leiterbahnen überkreuzenden Verbindungen zwischen jeweils zwei Leiterbahnen einen Kurzschluß zwischen den überkreuzten Leiterbahnen und den durch die Verbindung miteinander verbundenen Leiterbahnen herstellen.

Bei einem weiteren Verfahren dieser Art (FR-A 2 296 347 = DE-OS 25 58 367) ergibt sich das Problem, daß die Isolierschicht durchgehend auf Leiterbahnabschnitte und diesen benachbarte Bereiche des Basismaterials aufgebracht wird, wobei ibfolge des Höhenüberstandes der Leiterbahnen über das Basismaterial eine Oberfläche erhalten wird, die nicht eben ist. Dies ist für viele Anwendungsfälle nachteilig.

Es ist Aufgabe der Erfindung, Verfahren zur Herstellung von Digitalisier tabletts dahingehend zu verbessern, daß sich nach dem Auftragen des Isoliermaterials eine durchgehend ebene Isolierschicht ergibt.

Zur Lösung dieser Aufgabe wird ein Verfahren gemäß Oberbegriff des Anspruchs 1 durch die Merkmale des kennzeichnenden Teils dieses Anspruches ausgestaltet.

Mit dem erfindungsgemäßen Verfahren wird ein Digitalisiertablett hergestellt, dessen parallele Leiterbahnen wegen der Herstellung mittels Ätztechnik einen verhältnismäßig großen Leiterquerschnitt und damit geringen ohmschen Widerstand haben können, während die Verbindungen an den Enden der Leiterbahnen nach deren Herstellung aufgedruckt werden, so daß diese Verbindungen jeweils nur zwei Leiterbahnen verbinden, jedoch wegen der die Leiterbahnen im wesentlichen abdeckenden Isolierstoffschicht keine Verbindung mit den daswischenliegenden Leiterbahnen aufweisen und so auch keinen Kurzschluß bilden können.

Dabei kann zwar der Leitungsquerschnitt der Verbindungen wegen der Herstellung durch Drukken mittels elektrisch leitfähiger oder nachträglich metallisierbarer Druckfarbe deutlich geringer als derjenige der parallelen Leiterbahnen sein, doch verringert der dadurch höhere Widerstand in den Verbindungen den Gesamtwiderstand der miteinander verbundenen Leiterbahnen nur verhältnismäßig geringfügig, weil die Verbindungen im Verhältnis zu den übrigen Leiterbahnen sehr kurz sind.

Da außerdem das Metall der Leiterbahnen durch Kathodenzerstäubung, Aufdampfen, chemisches Aufdampfen oder stromlose Metallbeschichtung aufgetragen wird, läßt sich eine entsprechende Maske photographisch herstellen und das Aufbringen auf das Trägermaterial erfolgt, ohne daß dieses belastet wird, so daß das Trägermaterial nicht sehr stabil zu sein braucht.

Um eine ebene Abdeckung der Leiterbahnen durch die Isolierstoffschicht und damit eine durchgehend ebene Fläche zu erhalten, kann auf die die Leiterbahnen tragende Fläche eine die Leiterbahnen freilassende Isolierstoffbeschichtung aufgebracht werden, deren Dicke gleich der Dicke der Leiterbahnen ist, und die Isolierstoffschicht wird dann auf die Leiterbahn und die Isolierstoffbeschichtung aufgebracht.

Auf diese Weise füllt die Isolierstoffbeschichtung den Raum zwischen den Leiterbahnen aus und bildet zusammen mit diesen eine durchgehende, ebene Fläche für die Aufnahme der Isolierstoffbeschichtung.

Die Isolierstoffbeschichtung und/oder die Isolierstoffschicht können im Siebdruckverfahren aufgebracht werden, und auch die Druckfarbe kann im Siebdruckverfahren aufgedruckt werden.

Die Erfindung wird im folgenden anhand der Figuren näher erläutert.

Figur 1 zeigt in einer vereinfachten Draufsicht den Leiterbahn- und den Verbindungsverlauf eines Digitalisiertabletts.

Figur 2 zeigt in einer Teil-Explosionsdarstellung den Aufbau des Digitalisiertabletts im in Figur 1 strichpunktiert umrandeten Bereich.

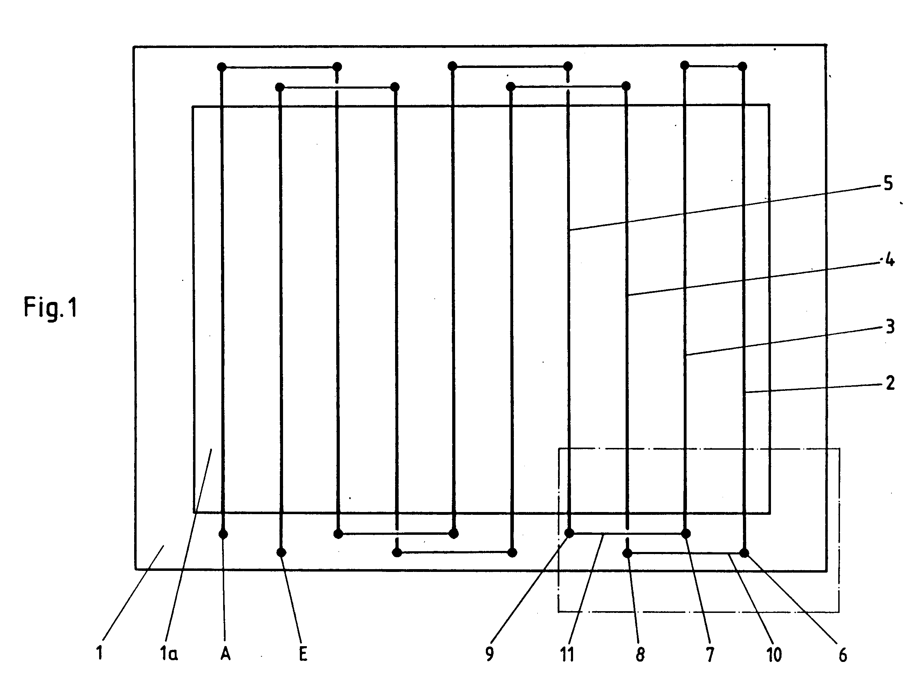

Das in Figur 1 schematisch dargestellte Digitalisiertablett hat eine aus einem Kunststoffträger, etwa einer Folie, bestehende Hauptfläche 1, auf der, wie durch eine Umrandung angedeutet, eine Arbeitsfläche 1a gebildet ist. Auf dieser Arbeitsfläche befinden sich parallel zueinander verlaufende, in gleichem Abstand voneinander angeordnete Leiterbahnen, von denen die sich teilweise in das strichpunktiert umrandete Feld erstreckenden Leiterbahnen mit den Bezugszeichen 2, 3, 4 und 5 bezeichnet sind. Die Enden einander nicht unmittelbar benachbarter Leiterbahnen, etwa die Enden 6 und 8 sowie 7 und 9 der Leiterbahnen 2, 4 bzw. 3, 5 sind durch Verbindungen, etwa 10 und 11 miteinander verbunden, wobei wie in Figur 1 zu erkennen ist, die oberen, nicht bezeichneten Enden der benachbarten Leiterbahnen 2 und 3 direkt miteinander verbunden sind. Alle Verbindungen sowie auch der Anfang A und das Ende E des auf diese Weise gebildeten Leitungsverlaufes liegen außerhalb der Arbeitsfläche 1a, und man erkennt, daß ein am Anfang A des Leitungsverlaufes zugeführter Impuls nacheinander alle Verbindungen und Leiterbahnen durchläuft, bis er am Ende E des Leitungsverlaufes austritt. Mittels eines oder mehrerer derartiger Impulse erfolgt in bekannter Weise die Ermittlung von bestimmten Punkten oder Bereichen auf der Arbeitsfläche 1a möglich, wobei zu berücksichtigen ist, daß an der

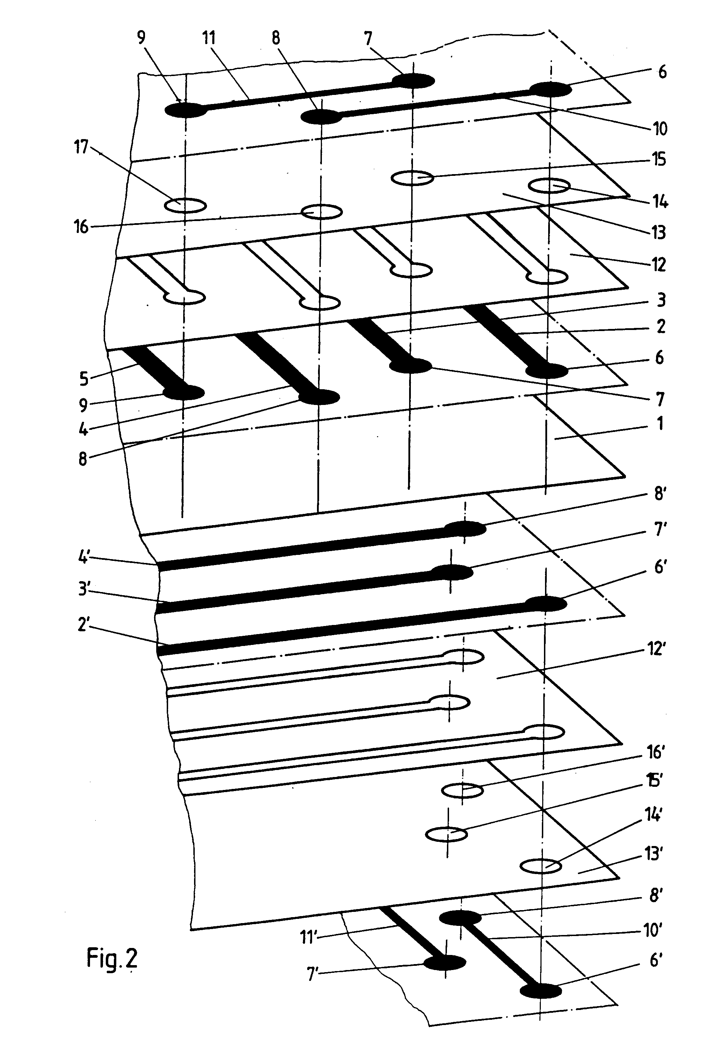

Unterseite der Fläche 1 eine ähnliche, jedoch um 90° gedrehte Anordnung von Leiterbahnen und Verbindungen vorgesehen ist, wie dies auch Figur 2 zu entnehmen ist.

In Figur 2 ist der die Fläche 1 bildende Kunststoffträger ohne die auf ihm angeordneten Leiterbahnen 2, 3, 4, 5 gemäß Figur 1 und ohne die an der Unterseite der Fläche 1 vorgesehenen Leiterbahnen 2', 3', 4' dargestellt.

In diesem Zusammenhang sei erwähnt, daß die in Figur 2 angedeutete Anordnung unterhalb der Fläche 1 im wesentlichen der Anordnung oberhalb der Fläche 1 entspricht, jedoch um 90° gedreht ist. Gleiche Bauelemente und Teile sind mit gleichen Bezugszeichen wie oberhalb der Fläche 1, jedoch zusätzlich mit ' gekennzeichnet und brauchen wegen der Übereinstimmung mit dem Aufbau oberhalb der Fläche 1 nicht näher erläutert zu werden.

Die Leiterbahnen 2, 3, 4, 5 einschließlich ihrer Enden 6, 7, 8, 9 werden durch Kathodenzerstäubung oder Aufdampfen, etwa von Kupfer oder einem Edelmetall auf die Fläche 1 aufgebracht. Danach wird auf diese Fläche, etwa im Siebdruckverfahren eine Isolierstoffbeschichtung 12 aufgetragen, die jedoch weder die Leiterbahnen 2, 3, 4, 5 noch deren Enden 6, 7, 8, 9 abdeckt, sondern lediglich den Bereich zwischen diesen bis genau zur Höhe der Leiterbahnen 2, 3, 4, 5 ausfüllt, so daß eine durchgehend ebene Fläche entsteht. Auf diese Fläche wird dann, wiederum vorzugsweise im Siebdruckverfahren eine Isolierstoffschicht 13 aufgebracht, die jedoch Aussparungen 14, 15, 16, 17 im Bereich der Leiterbahnenden 6, 7, 8, 9 aufweist, so daß die Isolierstoffschicht 13 die gesamte Isolierstoffbeschichtung 12 und die Leiterbahnen 2, 3, 4, 5 elektrisch isolierend abdeckt, jedoch die Enden 6, 7, 8, 9 freiläßt.

Schließlich werden auf die Isolierstoffschicht 13 mittels bekannter, elektrisch leitfähiger oder metallisierbarer Druckfarbe die Verbindungen 10, 11 aufgedruckt, wobei bei diesem Druckvorgang auch der Anschluß dieser Verbindungen 10, 11 mit den Leiterbahnenden 6, 8 und 7, 9 hergestellt wird, da diese durch die Aussparungen 14, 16 und 15, 17 hindurch zugänglich sind, während die aufgedruckten Verbindungen 10, 11 in ihrem übrigen Verlauf gegenüber den Leiterbahnen durch die Isolierstoffschicht 13 elektrisch isoliert sind.

**Patentansprüche**

1. Verfahren zur Herstellung eines Digitalisiertabletts mit zwei Gruppen von jeweils innerhalb der Gruppe parallelen Leiterbahnen ( 2,3,4,5,2',3',4'), die senkrecht zueinander verlaufen und fast koplanar angeordnet sind, bei dem die Leiterbahnen (2,3,4,5,2',3',4') einer Gruppe jeweils durch Kathodenzerstäubung oder Aufdampfen von Metallen hergestellt werden, dann eine Isolierschicht (13,13') unter Aussparung entsprechender Kontaktierungsbereiche (6,7,8,9,6',7',8') aufgebracht wird und anschließend mittels elektrisch leitfähiger oder metallisierbarer Druckfarben weitere Leiterstrukturen vorgesehen sind, **dadurch gekennzeichnet, daß** auf die die Leiterbahnen (2,3,4,5,2',3',4') einer Gruppe tragende Fläche (1) eine die Leiterbahnen (2,3,4,5,2',3',4') freilassende Isolierstoffbeschichtung (12,12') aufgebracht wird, deren Dicke gleich der Dicke der Leiterbahnen (2,3,4,5,2',3',4') ist, und daß die Isolierstoffschicht (13,13') auf die Leiterbahnen (2,3,4,5,2',3',4') und die Isolierstoffbeschichtung (12,12') aufgebracht wird.

**2.** Verfahren nach Anspruch 1, **dadurch gekennzeichnet,** daß die Isolierstoffbeschichtung (12; 12') im Siebdruckverfahren aufgebracht wird.

**3.** Verfahren nach einem der Ansprüche 1 bis 2, **dadurch gekennzeichnet,** daß die Isolierstoffschicht (13; 13') im Siebdruckverfahren aufgebracht wird.

**4.** Verfahren nach einem der Ansprüche 1 bis 3, **dadurch gekennzeichnet,** daß die Druckfarbe im Siebdruckverfahren aufgedruckt wird.

## Claims

**1.** A method for producing a digitising tablet with two groups of conductive tracks (2, 3, 4, 5 , 2', 3', 4') each parallel within the group which extend at right-angles to one another and are arranged in coplanar manner, in which the conductive tracks (2, 3, 4, 5, 2', 3', 4') of a group are each produced by cathode sputtering or vacuum metallization,then a layer of insulating material (13, 13') is applied by leaving free corresponding contact regions (6, 7, 8, 9, 6', 7', 8') and afterwards by means of electrically conductive or metallisable printing inks further conductive structures are provided, characterised in that a coating of insulating material (12, 12') which leaves the conductive tracks (2, 3, 4, 5, 2', 3', 4') free is applied to the surface (1) bearing the conductive tracks (2, 3, 4, 5, 2', 3', 4') of a group, the thickness of which coating is equal to the thickness of the conductive tracks (2, 3, 4, 5, 2', 3', 4'), and that the layer of insulating material (13; 13') is applied to the conductive tracks (2, 3, 4, 5, 2', 3', 4') and to the coating of insulating material (12, 12').

**2.** A method according to Claim 1, characterised in that the coating of insulating material (12; 12') is applied in a screen printing process.

**3.** A method according to one of Claims 1 to 2, characterised in that the layer of insulating material (13; 13') is applied in a screen printing process.

**4.** A method according to one of Claims 1 to 3, characterised in that the printing ink is printed in a screen printing process.

## Revendications

**1.** Procédé de fabrication d'une tablette de digitalisation avec deux groupes de pistes, les pistes (2, 3, 4, 5, 2', 3', 4') étant parallèles à l'intérieur de chaque groupe, les groupes sont perpendiculaires et coplanaires, on réalise les pistes d'un groupe par pulvérisation cathodique ou métallisation dans le vide, ensuite on dépose une couche d'isolant (13, 13') en laissant libres des zones de contact correspondantes, (6, 7, 8, 9, 6', 7', 8') et après au moyen des encres électriquement conductrices ou métallisables d'autres structures conductrices sont prévues, procédé caractérisé en ce qu'on dépose un revêtement d'isolant (12, 12') dégageant les pistes (2, 3, 4, 5, 2', 3', 4') sur la surface (1) portant les pistes (2, 3, 4, 5, 2', 3', 4') d'un groupe, dont l'épaisseur est égale à l'épaisseur des pistes (2, 3, 4, 5, 2', 3', 4') et qu'on dépose la couche d'isolant (13, 13') sur les pistes (2, 3, 4, 5, 2', 3',4') et le revêtement isolant (12, 12').

**2.** Procédé selon la revendication 1, caractérisé en ce que le revêtement isolant (12, 12') est déposé par procédé de sérigraphie.

**3.** Procédé selon l'une des revendications 1 à 2, caractérisé en ce que la couche d'isolant (13, 13') est déposé par procédé de sérigraphie.

**4.** Procédé selon l'une des revendications 1 à 3, caractérisé en ce qu'on imprime l'encre par procédé de sérigraphie.

Fig.1

Fig.2